Europäisches Patentamt

European Patent Office

Office européen des brevets

(11) Publication number: **0 419 078 A1**

## EUROPEAN PATENT APPLICATION

(21) Application number: 90309584.2

(22) Date of filing: 31.08.90

(51) Int. Cl.⁵: **H01B 11/12**, H03K 17/80, H03K 5/12, H03K 5/14

(30) Priority: 01.09.89 GB 8919814

(43) Date of publication of application:
27.03.91 Bulletin 91/13

(84) Designated Contracting States:
AT BE CH DE DK ES FR GR IT LI LU NL SE

(71) Applicant: EEV LIMITED
106 Waterhouse Lane
Chelmsford, Essex, CM1 2QU(GB)

(72) Inventor: Wilson, Colin Richard
Wardham Flat, University Hall
St. Andrews, Fife, Scotland(GB)
Inventor: Smith, Paul William
4A, Queen Gardens
St. Andrews, Fife KY16 9TA, Scotland(GB)

(74) Representative: Cockayne, Gillian et al
The General Electric Company plc Patent
Department GEC Marconi Research Centre
West Hanningfield Road
Great Baddow, Chelmsford Essex CM2
8HN(GB)

(54) Transmission lines.

(57) A transmission line includes dielectric material having a relative permittivity which is dependent on the strength of an applied electric field across it. As the electric field increases, the relative permittivity of the material decreases and thus the speed of propagation of a signal transmitted along the line is increased. The transmission line may be in the form of a dielectric shock line 11 to which pulses from a generator 9 are applied. As a pulse travels along the line 11, its rise time is reduced because higher amplitude parts of the pulse travel faster along the line than the low amplitude parts.

In another embodiment of the invention, the dielectric material is included in capacitors forming part of a lumped element ladder network.

FIG. 9

EP 0 419 078 A1

## TRANSMISSION LINES

This invention relates to transmission lines and more particularly, but not exclusively, to transmission lines which may be used to obtain reduced rise time of pulses transmitted along them.

There are various devices, such as for example pulsed lasers and accelerators, which are driven by applying relatively high power electrical pulses at a high repetition rate. One way in which the performance of such devices may be improved is by using magnetic switching to obtain pulse compression such that the amplitude of the applied pulses is increased and their rise time reduced.

A magnetic switch is an inductor which is wound on a magnetic core, the impedance of the inductor changing rapidly when the magnetic field in the core reaches a level at which the core saturates. If a voltage is applied across the inductor at a high enough value for a sufficiently long time, saturation of the core occurs. At saturation, the inductance of the winding on the core drops to a significantly lower value and the rate of rise of current through the inductor is increased. Thus, by employing magnetic switching in lumped element transmission lines or in magnetic shock-lines, the rise time of pulses travelling along them may be reduced. At present, it is possible to obtain pulses of 100 kV having a rise time of 300 ps.

The present invention arose from an attempt to provide transmission lines which are particularly suitable for producing pulse compression in which fast rise times may be achieved.

According to the invention there is provided transmission line apparatus comprising a transmission line which includes dielectric material having a relative permittivity which is dependent on the strength of an electric field applied across it.

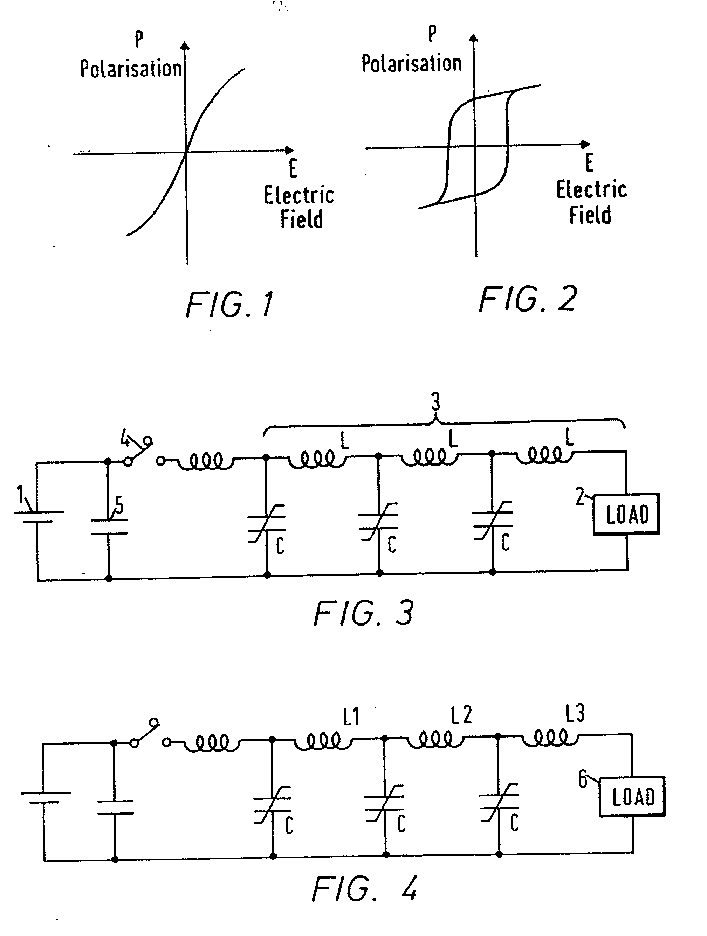

The properties of a material suitable for use in apparatus in accordance with the invention may be described by a graph which shows the change in polarisation of the material with applied electric field. The gradient of such a graph is proportional to the relative permittivity of the material. A graph for one suitable material, which is a polar dielectric, is shown in Figure 1. It can be seen that, as the electric field across the dielectric material is increased, its polarisation also increases but its rate of increase reduces with increasing electric field, and if the dielectric material is included in a capacitor, for example, the capacitance of the device drops as the field applied across it is increased.

When a dielectric material exhibiting these nonlinear electrical characteristics is included in a transmission line, the velocity of propagation of an electric signal through the material increases as its relative permittivity drops, the change in relative permittivity being dependent on the signal amplitude. This effect can therefore be used to produce pulses having a very fast rise time as lower amplitude parts of a pulse, at its beginning, will have a lower velocity along the line than higher amplitude parts. As the change in the characteristics of the material is dependent on change in polarisation, which is an extremely fast process, it should be possible to achieve much faster rise times than can be achieved using conventional magnetic switching, the performance of which is ultimately limited by the ferro-magnetic resonance properties of the material used or by the rate at which the domain walls within the material rotate.

It is believed that an arrangement in accordance with the invention could be made to work at extremely high voltages, in the range of several hundred kilovolts, and at high powers, possibly up to the 1 GW level.

Some materials which are particularly suitable for use with the invention are those known as ferro-electrics. These are materials which exhibit a spontaneous polarisation in the absence of an electric field across them. The graph showing the change of polarisation of such a material with applied electric field is a P-E loop, as shown in Figure 2. This loop is somewhat analogous to the B-H loop obtained for a magnetic material, the material exhibiting hysteresis. Some polar ferro-electrics which may be employed in apparatus in accordance with the invention are barium titanate or strontium titanate. However, polar dielectric materials other than ferro-electrics may be used. For example, there are a number of polar dielectric liquids, such as carbon disulphide $CS_2$, which may also be suitable.

In one advantageous embodiment of the invention, the dielectric material is included in a distributed transmission line, forming a dielectric shock-line. As a pulse travels along the transmission line, the lower amplitude portions of the rising pulse edge travel more slowly than high amplitude portions. Thus, the rising edge sharpens and the tail of the pulse is lengthened.

The distributed transmission line could be one of a number of different types. For example, in one arrangement, the distributed transmission line may take the form of a parallel plate transmission line.

The distributed transmission line may be tapered such that its cross-sectional area over at least part of its length is non-uniform. In such a line, the distributed inductance increases as the cross-sectional area increases and the distributed capacitance decreases. Thus, when a pulse travels along the line, its rising edge becomes sharper and also its amplitude increases as the capacitance decreases, producing an electromagnetic shock wave.

In another embodiment of the invention, the transmission line is of the lumped element type and preferably includes inductors and capacitors arranged as a ladder network, the capacitors including the said dielectric material. As a pulse is transmitted along the network, its rise time is reduced at each stage. Satisfactory performance may be obtained using only one stage but generally it is preferred to include a plurality of stages so as to give a greater reduction in the pulse rise time.

The inductors and capacitors of the network may be substantially identical. In an alternative embodiment, however, the values of the inductors may be progressively decreased along the transmission line whilst each capacitor has the same value at zero stress. By using such a network, the number of sections needed to achieve a given rise time may be less than would be the case were the inductors to be identical. As in the arrangement in which the inductors are of the same value, sharpening of a pulse rising edge occurs as the electric field increases across the dielectric material of the capacitors. In addition, the rise time is further reduced because the inductors are reduced in value along the line, giving enhanced performance.

It may be preferred to arrange the ladder network such that, as a pulse travels along it, it encounters both capacitors and inductors which are successively lower in value. Thus, the rise time of the pulse gets shorter with each stage and furthermore, its amplitude increases as pulse compression occurs. Pulse compression is achieved because, as a constant charge flows along the line and encounters successively lower capacitances, then the voltage across the capacitors must increase.

It may be advantageous for some applications to use both saturating magnetic materials as the inductors and dielectric materials exhibiting non-linear characteristics in the capacitors. This enables the impedance of the transmission line to be maintained at a constant level if both the magnetic and dielectric materials are arranged to saturate together by suitably choosing their characteristics. Constant impedance lines are electrically efficient as it is possible to achieve good electrical matching at both the input and output of the transmission line. In such an arrangement, the inductors may be substantially identical or may progressively decrease in value along the line. In the latter case, the capacitor values must also decrease by a corresponding amount to enable the impedance to be kept constant along the transmission line.

It is believed that, by employing the invention, extremely fast rise times may be achieved and that optical frequencies may be reached. In some applications, therefore, it may be advantageous to arrange that the transmission line is capable of transmitting optical radiation along at least part of its length.

According to a first feature of the invention, a transmission line arrangement includes: first and second substantially identical transmission lines, each being in accordance with the invention, arranged electrically in parallel; a signal inverter following the second transmission line; and means for combining the signal transmitted through the first transmission line with that transmitted through the inverter, there being a delay between the signal passed through one transmission line and that through the other. By employing such an arrangement, the fall time of a pulse applied to it may be controlled in addition to the pulse rise time, permitting rapid termination to be implemented. The delay may be variable, giving a variable pulse length at the output of the combining means.

According to a second feature of the invention, a pulse compression arrangement comprises transmission line apparatus in accordance with the invention and includes means for applying a series of pulses to the or each transmission line whereby the pulses are compressed and the compressed pulses applied to a load.

Some ways in which the invention may be performed are now described by way of example only with reference to the accompanying drawings in which:

Figures 3, 4, 5 and 6 illustrate respective pulse compression arrangements which each include a lumped element transmission line in accordance with the invention;

Figures 7 and 8 illustrate respective single stage transmission lines in accordance with the invention;

Figures 9 and 10 schematically show shock lines in accordance with the invention; and

Figure 11 is a schematic block diagram of an arrangement in accordance with the invention.

With reference to Figure 3, an arrangement for reducing pulse rise times includes a transmission line in accordance with the invention which is of the lumped element ladder network type.

A voltage source 1 is arranged to deliver energy to a load 2 via a transmission line section 3 which includes a plurality of inductors L and capacitors C. The capacitors include a polar dielectric material which may be ferro-electric and have the property that, as the electric field across them increases, their capacitance decreases. The inductors are substantially identical as are the capacitors, which have the same value at zero stress.

When a switch 4 is closed, a pulse of energy from a capacitor 5 connected across the source 1 is transmitted along the section 3. Initially, the capacitance of the first capacitor C1 is relatively high but as the potential across it increases, its value falls. As the pulse travels along the transmission line, its rise time decreases at each stage, the characteristic delay time per section decreasing as the electric field across the dielectric material increases.

In another embodiment of the invention, illustrated in Figure 4, a lumped element transmission line includes capacitors C which are again substantially identical. The transmission line section also includes a series of inductors L1, L2 and L3, each inductor having a lower value than the preceding one, the lowest value inductor L3 being connected to the load 6. The arrangement enables a shorter rise time to be achieved than that illustrated in Figure 3 because, in addition to the steepening of the rising edge caused by the change in relative permittivity of the dielectric material included in the capacitors C, the reduction in values of the inductors along the line also has an effect in reducing rise time.

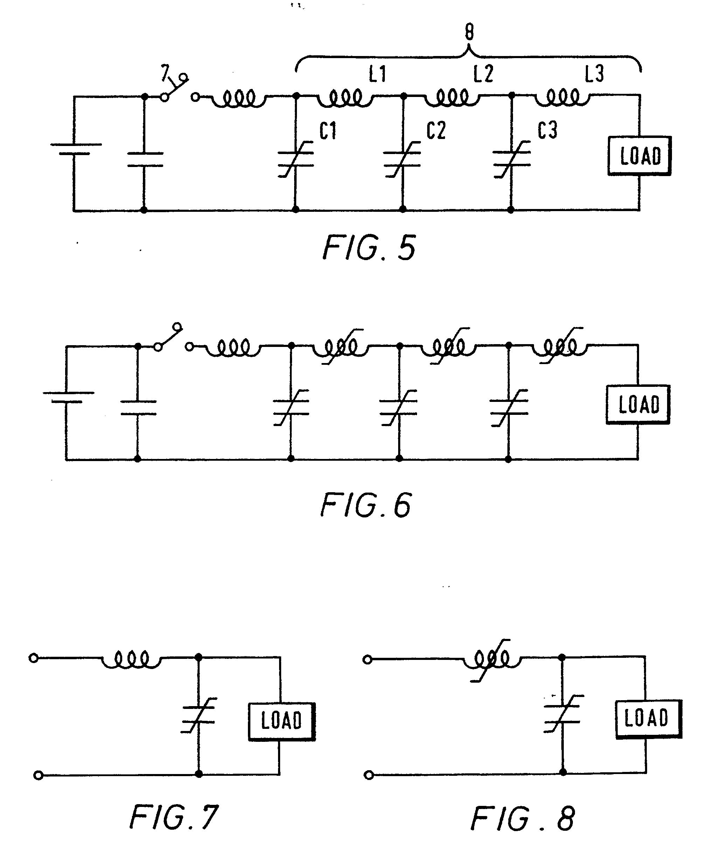

With reference to Figure 5, in another transmission line in accordance with the invention, the values of the inductors decrease along the transmission line, as in the embodiment shown in Figure 4. A plurality of capacitors C1, C2 and C3 are included, which have values which also progressively decrease along the transmission line section 8, C3 being of the lowest value. The capacitors include ferro-electric material in accordance with the invention.

When a switch 7 is closed, a pulse of energy is transmitted along the section 8. Initially, the capacitance of the first capacitor C1 is relatively high but as the potential across it increases its value falls. As energy is transferred between the capacitors C1, C2 and C3 the rise time of the voltage pulse is decreased. Also, the voltage pulse becomes compressed and its amplitude increases.

In another embodiment of the invention, illustrated in Figure 6, the inductors are arranged to saturate so as to act as magnetic switches. The saturation characteristics of the magnetic and dielectric materials are matched so as to give substantially constant impedance along the transmission line, enabling good electrical matching to be achieved. In the example shown, the inductors are of the same value, as are the capacitors. However, they may both be arranged to decrease in value along the length of the transmission line.

Figures 7 and 8 illustrate two transmission lines which consist of only one section each. The transmission line shown in Figure 7 includes an inductor of constant value and a capacitor including a nonlinear dielectric material. The transmission line of Figure 8 includes a saturable inductor to enable constant impedance matching to be implemented.

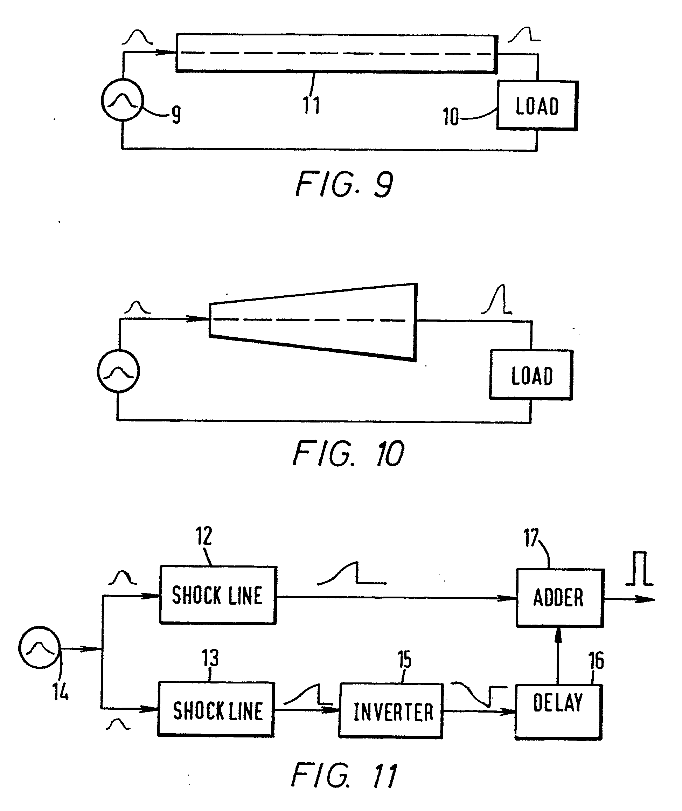

Figure 9 illustrates an arrangement in which a pulse generator 9 delivers energy to a load 10 via a dielectric shock line 11. In this case, the line is filled with a ferro-electric or other polar dielectric material such as a material which contains barium titanate.

As the amplitude of the voltage pulse delivered from generator 9 increases, it causes the value of the relative permittivity of the dielectric material in the shock line 11 to decrease. This causes the rising edge of the pulse to speed up as the lower amplitude portions of the rising pulse edge travel more slowly than high amplitude parts of the pulse.

The dielectric material may be transmissive to optical radiation to enable high frequency signals to be transmitted along the shock line 11.

With reference to Figure 10, a distributed transmission line is tapered such that it increases in diameter in a direction along the line to the load. This configuration gives a decrease in rise time of a pulse transmitted along it, together with pulse compression.

With reference to Figure 11, a pulse generation arrangement includes two substantially identical dielectric shock lines 12 and 13 arranged electrically in parallel and connected to receive the output of a pulse generator 14. The output of the shock lines 13 is applied to an inverter 15 followed by a delay 16, which can be set to a desired value, and then combined with the output of the other shock line 12 at an adder 17. Again, the shock lines 12 and 13 are formed of a dielectric material having a relative permittivity which is dependent on the strength of an applied electric field. Although conveniently this material is a polar ferro-electric, it could be any nonlinear dielectric material, including liquids such as carbon disulphide for example.

During operation of the arrangement, the output of generator 14 is applied simultaneously to the shock lines 12 and 13 which both operate in the same manner as that described with reference to Figure 9, producing pulses having very fast rise times. The pulse from shock-line 13 is then applied to the inverter 15, which is a transmission line transformer in this case. The inverted pulse is passed via the delay 16 to the adder 17. The output of the adder 17 is thus a pulse, the width of which is governed by a value of the delay 16, having rise and fall times which are very short. The delay 16 may be variable to enable the resultant pulse length to be changed.

**Claims**

1. Transmission line apparatus comprising a transmission line which includes dielectric material having a relative permittivity which is dependent on the strength of an electric field applied across it.

2. Apparatus as claimed in claim 1 wherein the transmission line is a distributed transmission line.

3. Apparatus as claimed in claim 2 wherein the distributed transmission line is tapered such that its transverse cross-section over at least part of its length is non-uniform.

4. Apparatus as claimed in claim 1 wherein the transmission line includes lumped elements.

5. Apparatus as claimed in claim 4 wherein the transmission line is a lumped element ladder network including inductors and capacitors, the capacitors including the said dielectric material.

6. Apparatus as claimed in claim 5 wherein the inductors are of saturable magnetic material and arranged to act as magnetic switches.

7. Apparatus as claimed in claim 5 or 6 wherein the inductors are arranged in a series such that their values progressively decrease along the line.

8. Apparatus as claimed in claim 5, 6 or 7 wherein the capacitors are arranged in a series such that their values under zero electrical stress progressively decrease along the line.

9. Apparatus as claimed in any preceding claim wherein the dielectric material is a polar ferroelectric material.

10. Apparatus as claimed in any preceding claim wherein the dielectric material is a liquid.

11. Apparatus as claimed in any preceding claim wherein the transmission line is capable of transmitting optical radiation along at least part of its length.

12. A transmission line arrangement comprising apparatus as claimed in any preceding claim, and including: substantially identical first and second transmission lines, each including said dielectric material, arranged electrically in parallel; a signal inverter following the second transmission line; and means for combining the signal transmitted through the first transmission line and that transmitted through the inverter, there being a delay between the signals passed through the first and second transmission lines.

13. A pulse compression arrangement comprising transmission line apparatus as claimed in any preceding claim and including means for applying a series of pulses to the or each transmission line whereby the pulses are compressed and means for applying the compressed pulses to a load.

FIG. 1

FIG. 2

FIG. 3

FIG. 4

FIG. 5

FIG.6

FIG.7

FIG . 8

FIG. 9

FIG. 10

FIG. 11

## EUROPEAN SEARCH REPORT

**European Patent Office**

Application Number

**EP 90 30 9584**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 719 429   (IKEZI et al.)<br>* Column 1, line 33 - column 3, line 3; figure 1A *<br>— — — | 1,2,4,9 | H 01 B 11/12<br>H 03 K 17/80<br>H 03 K 5/12<br>H 03 K 5/14 |
| Y | | 3,10,12 | |
| X | INSTRUM.<br>& EXP. TECHN., vol. 20, no. 1, January/February 1977,<br>pages 130-132; Y.V. MAKRITSKII: "Generator of current<br>pulses with sharp leading edge"<br>* Page 131, lines 5-26; figures 1,2 *<br>— — — | 1,2,4,5,6,<br>8,9,13 | |
| Y | IDEM<br>— — — | 7 | |
| Y | PATENT ABSTRACTS OF JAPAN, vol. 5, no. 59<br>(E-53)[731], 22nd April 1981;<br>& JP-A-56 8914 (TOKYO SHIBAURA) 29-01-1981<br>* Abstract *<br>— — — | 3 | |
| Y | AMERICAN INSTITUTE OF ELECTRICAL ENGINEERS,<br>PROCEEDINGS SPECIAL TECHNICAL CONFERENCE ON<br>NONLINEAR MAGNETICS AND MAGNETIC AMPLIFIERS,<br>Washington, 23rd - 25th September 1959, pages 234-254,<br>New York, US; E.W. MANTEUFFEL et al.: "Direct current<br>charged magnetic pulse modulator"<br>* Page 244, lines 38-39; page 254, figure 9 *<br>— — — | 7 | TECHNICAL FIELDS<br>SEARCHED (Int. Cl.5)<br><br>H 03 K |
| Y | PATENT ABSTRACTS OF JAPAN, vol. 7, no. 30<br>(P-173)[1175], 5th February 1983;<br>& JP-A-57 182 116 (SHOWA DENKO K.K.) 09-11-1982<br>* Abstract *<br>— — — | 10 | |
| Y | GB-A-1 121 354   (SCM CORP.)<br>* Page 4, line 93 - page 6, line 126; figures 1,6 *<br>— — — — — | 12 | |

The present search report has been drawn up for all claims

| Place of search | Date of completion of search | Examiner |
|---|---|---|
| The Hague | 11 December 90 | CANTARELLI R.J.H. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document